# EUROPEAN PATENT APPLICATION

(11) **EP 2 620 990 A2**
(43) Date of publication of application: **31.07.2013**
(21) Application number: 13152007.4
(22) Date of filing: 21.01.2013
(51) Int. Cl.: H01L 33/56, B29C 43/18

(54) **Light emitting diode device and method of producing the same**

(30) Priority: 27.01.2012 JP 2012015796
(71) Applicant: NITTO DENKO CORPORATION, Ibaraki-shi, Osaka 567-8680 (JP)
(72) Inventor: Katayama, Hiroyuki, Osaka, 567-8680 (JP); Ooyabu, Yasunari, Osaka, 567-8680 (JP); Sato, Satoshi, Osaka, 567-8680 (JP)
(74) Representative: HOFFMANN EITLE

(57) **Abstract**

A method of producing a light emitting diode device (1) includes preparing an encapsulating resin layer (3); embedding a light emitting diode element (2) in the encapsulating resin layer (3); and heating while pressing with gas the encapsulating resin layer having the light emitting diode element (2) being embedded therein.

## Description

### BACKGROUND OF THE INVENTION

### Field of the Invention

The present invention relates to a light emitting diode device and a method of producing the light emitting diode device. More particularly, the present invention relates to a light emitting diode device having a light emitting diode element being encapsulated by an encapsulating resin layer, and a method of producing the light emitting diode device.

### Description of Related Art

It has been known that a light emitting diode device is produced through encapsulating a light emitting diode element (LED) by an encapsulating resin layer.

For instance, the following method has been proposed. See, for example, Japanese Unexamined Patent Publication No. 2011-228525A.

Specifically, an encapsulating material is formed on a substrate having an optical semiconductor element mounted thereon so as to cover the optical semiconductor element. Subsequently, they are heated while being nipped by press plates to be subjected to vacuum press by a vacuum press device under reduced pressure, whereby the encapsulating material is cured. Then the encapsulating material encapsulates the optical semiconductor element to produce an optical semiconductor device. Such a method has been proposed.

Japanese Unexamined Patent Publication No. 2011-228525A discloses a method in which pressing by the vacuum press can reduce occurrence of voids (bubbles) in the encapsulating material.

### SUMMARY OF THE INVENTION

In the method described in Japanese Unexamined Patent Publication No. 2011-228525A, however, since the encapsulating material is pressed and heated while being nipped by the press plates, the following problems may arise. That is, in higher pressure and a longer heating time, a load may be applied to the device. Moreover, the encapsulating material (sheet) may be deformed and warped or is easily damaged due to the pressure.

Moreover, in the vacuum press, forced pressure on the optical semiconductor element becomes easily non-uniform under higher pressure. In this case, the optical semiconductor element may be damaged, or voids may be left in the encapsulating resin layer.

The present invention has one object to provide a method of producing a light emitting diode device and a light emitting diode device obtained by the method, the method being capable of producing the light emitting diode device with suppressed damages of the light emitting diode element and suppressed occurrence of voids in an encapsulating resin layer and with a suppressed load to equipment.

The method of producing a light emitting diode device according to the present invention is a method of producing a light emitting diode device in which a light emitting diode element is encapsulated by an encapsulating resin layer. The method includes preparing an encapsulating resin layer; embedding a light emitting diode element in the encapsulating resin layer; and heating while pressing with gas the encapsulating resin layer having the light emitting diode element being embedded therein.

In the production method of the light emitting diode device, it is preferable that the encapsulating resin layer is formed of a thermosetting resin in a B-stage.

In the production method of the light emitting diode device, it is preferable that the encapsulating resin layer has a compressive elasticity modulus of 0.01 to 1 MPa at 25°C.

In the production method of the light emitting diode device, it is preferable that the encapsulating resin layer is pressed at 2 to 20 atmospheres in the step of heating while pressing with gas the encapsulating resin layer.

In the production method of the light emitting diode device, it is preferable that the encapsulating resin layer is heated while being pressed with an autoclave in the step of heating while pressing with gas the encapsulating resin layer.

The light emitting diode device is produced by the production method of the light emitting diode device mentioned above.

According to the production method of the light emitting diode device of the present invention for producing the light emitting diode device of the present invention, the encapsulating resin layer with the light emitting diode element embedded therein is heated while being pressed with gas.

Thus, a load applied to the device can be suppressed when pressure is higher and a heating time becomes longer.

Moreover, pressing with gas can achieve uniform forced pressure on the light emitting diode element under higher pressure. As a result, damages of the light emitting diode element and occurrence of voids in the encapsulating resin layer can be suppressed.

### BRIEF DESCRIPTION OF THE DRAWINGS

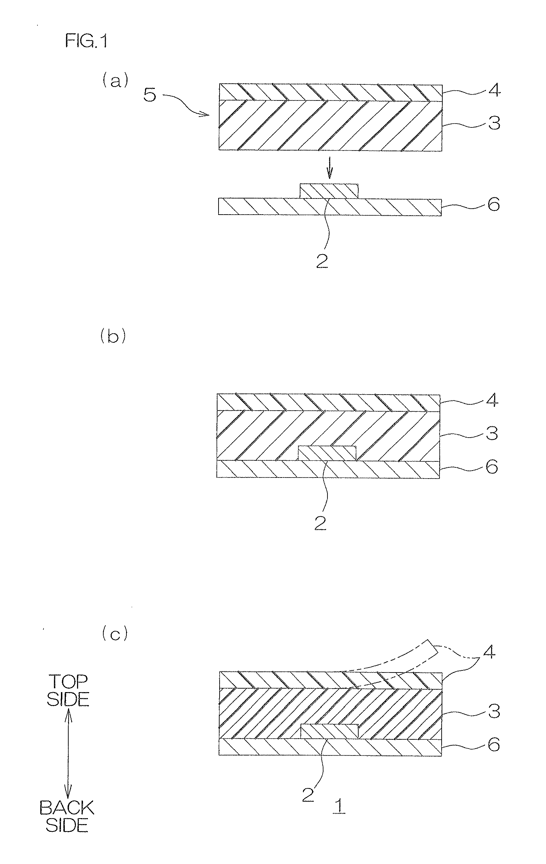

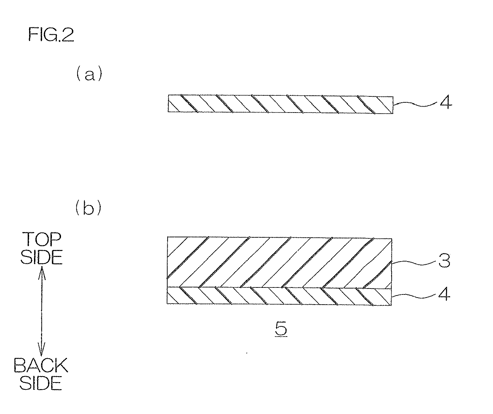

Figure 1 shows process drawings for illustrating one embodiment of a producing method of a light emitting diode device according to the present invention:
   (a) illustrating a step of arranging an encapsulating sheet and a substrate so as to be opposed to each other,
   (b) illustrating a step of embedding a light emitting diode element in an encapsulating resin layer, and
   (c) illustrating a step of heating while pressing with gas the encapsulating resin layer. Figure 2 shows process drawings for illustrating a method of preparing the encapsulating sheet illustrated in Figure 1(a):
      (a) illustrating a step of preparing a base substrate, and
      (b) illustrating a step of laminating the encapsulating resin layer onto the base substrate.

### DETAILED DESCRIPTION OF THE INVENTION

Figure 1 shows process drawings for illustrating one embodiment of a producing method of a light emitting diode device according to the present invention. Figure 2 shows process drawings for illustrating a method of preparing the encapsulating sheet shown in Figure 1(a).

This method is a method of producing a light emitting diode device 1 in which a light emitting diode element 2 is encapsulated by an encapsulating resin layer 3, as illustrated in Figure 1. The method includes preparing an encapsulating resin layer 3 (see Figure 1(a)); embedding a light emitting diode element 2 in the encapsulating resin layer 3 (i.e., an embedding step, see Figure 1(b)); and heating while pressing with gas the encapsulating resin layer 3 with the light emitting diode element 2 embedded therein (i.e., a gas-pressing/heating step, see Figure 1(c)).

For instance, in order to prepare the encapsulating resin layer 3, an encapsulating sheet 5 is prepared having a base substrate 4 and the encapsulating resin layer 3 formed on a back face thereof, as illustrated in Figure 1(a).

In order to prepare the encapsulating sheet 5 in Figure 1 (a), the base substrate 4 is firstly prepared as shown in Figure 2 (a).

The base substrate 4 is a protective sheet that covers and protects a surface (top face) of the encapsulating resin layer 3 (see Figure 2(b)), or a coating base substrate of the encapsulating resin layer 3.

The base substrate 4 is not particularly limited, and examples thereof include a resin film including a polyester film such as a polyethylene terephthalate (PET) film; a polycarbonate film: a polyolefin film such as a polyethylene film and a polypropylene film; a polystyrene film; an acrylic film; a silicone resin film and a fluororesin film. In addition, examples of the base substrate 4 further include metallic foil such as copper foil and stainless foil.

A resin film is preferable, and a polyester film is more preferable among the examples of the base substrate 4.

The base substrate 4 has a surface (a face on which the encapsulating resin layer 3 is to be formed) that is subjected to a releasing treatment, as required, for an enhanced releasing property from the encapsulating resin layer 3.

A thickness of the base substrate 4 is not particularly limited. The thickness is, in view of a handling property, costs, and the like, for example, from 10 to 200 µm, and preferably from 20 to 100 µm.

Subsequently, in the method, the encapsulating resin layer 3 is laminated onto the surface of the base substrate 4 as shown in Figure 2(b).

First, the entire surface of the base substrate 4 is coated with an encapsulating resin composition, to be mentioned later in detail, using a well-known coating method, such as a doctor blade, a gravure coater, a fountain coater, a cast, a spin, and a roll, for laminating the encapsulating resin layer 3 onto the surface of the base substrate 4.

Examples of the encapsulating resin composition include a resin including a thermosetting resin such as a silicone resin, an epoxy resin, a polyimide resin, a phenol resin, a urea resin, a melamine resin and an unsaturated polyester resin; and a thermoplastic resin such as an acrylic resin, a fluororesin, and a polyester resin.

Of the encapsulating resin composition, a preferable example is a thermosetting resin, and a more preferable example is a silicone resin.

Examples of the silicone resin include a thermosetting silicone resin composition with two systems of reaction (systems of reaction in a curing reaction).

Examples the thermosetting silicone resin composition with two systems of reaction include a condensation/addition reaction curing-type silicone resin composition with two systems of reaction of a condensation reaction and an addition reaction.

Specifically, the condensation/addition reaction curing-type silicone resin composition can be subjected to a condensation reaction (silanol condensation) by heating, which enables to be brought into a semi-cured state (B-stage). Thereafter, the composition can be subjected to an addition reaction (hydrosilyl addition) by further heating, which enables to be brought into a cured state (completely cured state).

Examples of the condensation/addition reaction curing-type silicone-resin composition include a first thermosetting silicone resin composition, a second thermosetting silicone resin composition, a third thermosetting silicone resin composition, and a fourth thermosetting silicone resin composition. The first thermosetting silicone resin composition contains a polysiloxane containing silanol groups at both ends, an ethylenically unsaturated hydrocarbon group-containing silicon compound (hereinafter, referred to as an ethylenical silicon compound), an epoxy group-containing silicon compound, and an organohydrogensiloxane. The second thermosetting silicone resin composition contains a first organopolysiloxane having at least two alkenylsilyl groups in one molecule, a second organopolysiloxane having at least two hydrosilyl groups in one molecule, a hydrosilylation catalyst, and a curing retarder. The third thermosetting silicone resin composition contains a first organopolysiloxane having, in one molecule, both at least two ethylenically unsaturated hydrocarbon groups and at least two hydrosilyl groups, a second organopolysiloxane having, in one molecule, at least two hydrosilyl groups without containing an ethylenically unsaturated hydrocarbon group, a hydrosilylation catalyst, and a hydrosilylation retarder. The fourth thermosetting silicone resin composition contains a first organopolysiloxane having, in one molecule, both at least two ethylenically unsaturated hydrocarbon groups and at least two silanol groups, a second organopolysiloxane having, in one molecule, at least two hydrosilyl groups without containing an ethylenically unsaturated hydrocarbon group, and a hydrosilylation catalyst.

The first thermosetting silicone resin composition is a preferable example of the condensation/addition reaction curing-type silicone resin composition.

In the first thermosetting silicone resin composition, the polysiloxane containing silanol groups at both ends, the ethylenical silicon compound, the epoxy group-containing silicon compound are condensation materials (materials for a condensation reaction). The ethylenical silicon compound and the organohydrogensiloxane are addition materials (materials for an addition reaction).

The polysiloxane containing silanol groups at both ends is an organosiloxane containing silanol groups (SiOH groups) at both ends of a molecule represented by general formula (1) below.

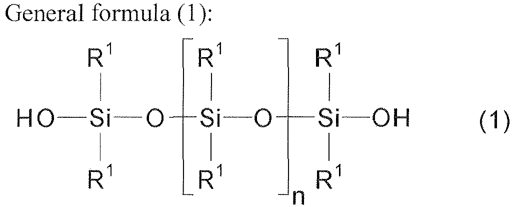

(where R¹ represents a monovalent hydrocarbon group selected from a saturated hydrocarbon group and an aromatic hydrocarbon group, and n represents an integer of 1 or more.)

In the monovalent hydrocarbon group represented by R¹in general formula (1) above, examples of the saturated hydrocarbon group include a straight-chain or branched alkyl group having 1 to 6 carbon atoms (such as a methyl group, an ethyl group, a propyl group, an isopropyl group, a butyl group, an isobutyl group, a pentyl group, and a hexyl group); and a cycloalkyl group having 3 to 6 carbon atoms (such as a cyclopentyl group and a cyclohexyl group).

In the monovalent hydrocarbon group represented by R¹ in general formula (1) above, examples of the aromatic hydrocarbon group include an aryl group having 6 to 10 carbon atoms (such as a phenyl group and a naphthyl group).

In general formula (1) above, R¹s may be the same or different from each other. Preferably, R¹s are the same.

Of the monovalent hydrocarbon group, a preferable example is an alkyl group having 1 to 6 carbon atoms and an aryl group having 6 to 10 carbon atoms, and, in view of transparency, thermal stability, and light resistance, a more preferable example is a methyl group.

Reference n in general formula (1) above is, in view of stability and handling properties, preferably an integer of 1 to 10,000, and more preferably an integer of 1 to 1,000.

Here, reference n in general formula (1) above is determined as an average value.

Specifically, examples of the polysiloxane containing silanol groups at both ends include a polydimethylsiloxane containing silanol groups at both ends, a polymethylphenylsiloxane containing silanol groups at both ends and a polydiphenylsiloxane containing silanol groups at both ends.

Such the polysiloxane containing silanol groups at both ends may be used either alone or as a combination thereof.

Moreover, in such polysiloxane containing silanol groups at both ends, a polydimethylsiloxane containing silanol groups at both ends is a preferable example.

A commercially available product or a product synthesized according to a known method may be used for the polysiloxane containing silanol groups at both ends.

The number average molecular weight of the polysiloxane containing silanol groups at both ends is of, in view of stability and/or a handling property, for example 100 to 1,000,000, or preferably 200 to 100,000. The number average molecular weight is determined in terms of polystyrene by gel permeation chromatography. Likewise, the number average molecular weight of materials other than the polysiloxane containing silanol groups at both ends, to be mentioned later, is determined.

The silanol group equivalent in such polysiloxane containing silanol groups at both ends is of, for example, 0.002 to 25 mmol/g, preferably 0.02 to 25 mmol/g.

The polysiloxane containing silanol groups at both ends is blended at a mixing ratio of, for example, 1 to 99.99 parts by mass, preferably 50 to 99.9 parts by mass, more preferably 80 to 99.5 parts by mass with respect to 100 parts by mass of the condensation materials.

The ethylenically silicon compound is a silane compound having both an ethylenically unsaturated hydrocarbon group and a leaving group in the silanol condensation reaction represented by general formula (2) below.

General formula (2):

R²-Si(X¹)₃ (2)

(where R² represents an ethylenically unsaturated monovalent hydrocarbon group, and X¹ represents a halogen atom, an alkoxy group, a phenoxy group, or an acetoxy group, provided that X¹ may be the same or different from each other.)

In general formula (2) above, examples of the ethylenically unsaturated hydrocarbon group represented by R² include a substituted or unsubstituted ethylenically unsaturated hydrocarbon group. Examples thereof include an alkenyl group and a cycloalkenyl group.

Examples of the alkenyl group include an alkenyl group having 2 to 10 carbon atoms such as a vinyl group, an allyl group, a propenyl group, a butenyl group, a pentenyl group, a hexenyl group, a heptenyl group, and an octenyl group.

Examples of the cycloalkenyl group include a cycloalkenyl group having 3 to 10 carbon atoms such as a cyclohexenyl group and a norbornenyl group.

Of the ethylenically unsaturated hydrocarbon group, in view of reactivity with the hydrosilyl group, a preferable example is an alkenyl group, a more preferable example is an alkenyl group having 2 to 5 carbon atoms, and a further more preferable example is a vinyl group.

Reference X¹ represents the leaving group in the silanol condensation reaction in general formula (2) above, whereas reference SiX¹ represents the reactive functional group in the silanol condensation reaction in general formula (2) above.

In general formula (2) above, examples of the halogen atom represented by X¹ include bromine, chlorine, fluorine, and iodine.

Examples of the alkoxy group represented by X¹ in general formula (2) above include an alkoxy group containing a straight-chain or branched alkyl group having 1 to 6 carbon atoms (such as a methoxy group, an ethoxy group, a propoxy group, an isopropoxy group, a butoxy group, an isobutoxy group, a pentyloxy group, and a hexyloxy group); and alkoxy group containing a cycloallcyl group having 3 to 6 carbon atoms (such as a cyclopentyloxy group and a cyclohexyloxy group).

In general formula (2) above, X¹s may be the same or different from each other. Preferably, X¹s are the same.

Of X¹ in general formula (2) above, a preferable example is an alkoxy group, and a more preferable example is a methoxy group.

Examples of such the ethylenical silicon compound include an ethylenically unsaturated hydrocarbon group-containing trialkoxysilane, an ethylenically unsaturated hydrocarbon group-containing silane trihalide, an ethylenically unsaturated hydrocarbon group-containing triphenoxysilane, and an ethylenically unsaturated hydrocarbon group-containing triacetoxysilane.

Such the ethylenical silicon compound may be used either alone or as a combination thereof.

Of such the ethylenical silicon compound, a preferable example is an ethylenically unsaturated hydrocarbon group-containing trialkoxysilane.

Examples of the ethylenically unsaturated hydrocarbon group-containing trialkoxysilane include a vinyltrialkoxysilane such as a vinyltrimethoxysilane, a vinyltriethoxysilane and a vinyltripropoxysilane; an allyltrimethoxysilane; a propenyltrimethoxysilane; a butenyltrimethoxysilane; and a cyclohexenyltrimethoxysilane.

Of such the ethylenically unsaturated hydrocarbon group-containing trialkoxysilane, a preferable example is a vinyltrialkoxysilane, and a more preferable example is a vinyltrimethoxysilane.

The ethylenical silicon compound is blended at a mixing ratio of, for example, 0.01 to 90 parts by mass, preferably 0.01 to 50 parts by mass, and more preferably 0.01 to 10 parts by mass with respect to 100 parts by mass of the condensation materials.

The above-described ethylenical silicon compound may be a commercially available product, or can be synthesized for use according to a known method.

The epoxy group-containing silicon compound is a silane compound having both an epoxy group and a leaving group in the silanol condensation reaction represented by general formula (3) below.

General formula (3):

R³-Si(X²)₃ (3)

(where R³ represents an epoxy structure-containing group, and X² represents a halogen atom, an alkoxy group, a phenoxy group, or an acetoxy group, provided that X² may be the same or different from each other.)

Examples of the epoxy structure-containing group represented by R³ in general formula (3) include an epoxy group, a glycidylether group, and an epoxycycloalkyl group such as an epoxycyclohexyl group.

Of the epoxy structure-containing group, an preferable example is a glycidylether group. Specifically, the glycidylether group is a glycidoxyalkyl group represented in general formula (4) below.

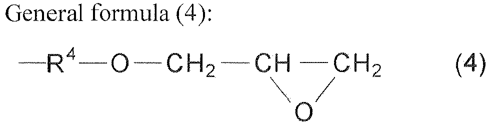

(where R⁴ represents a divalent hydrocarbon group selected from a saturated hydrocarbon group and an aromatic hydrocarbon group).

Examples of the saturated hydrocarbon group in the divalent hydrocarbon group represented by R⁴ in general formula (4) above include an alkylene group having 1 to 6 carbon atoms (such as a methylene group, an ethylene group, a propylene group, and a butylene group); and a cycloalkylene group having 3 to 8 carbon atoms (such as a cyclopentylene group and a cyclohexylene group).

Examples of the aromatic hydrocarbon group in the divalent hydrocarbon group represented by R⁴ in general formula (4) above include an arylene group having 6 to 10 carbon atoms (such as a phenylene group and a naphthylene group).

Of such the divalent hydrocarbon group, a preferable example is an alkylene group having 6 to 10 carbon atoms, and a more preferable example is a propylene group.

Specifically, examples of the glycidylether group include a glycidoxymethyl group, a glycidoxyethyl group, a glycidoxypropyl group, glycidoxycyclohexyl group, and a glycidoxyphenyl group.

Of such the glycidylether group, a preferable example is a glycidoxypropyl group.

Here, X² in general formula (3) above represents a leaving group in the silanol condensation reaction, whereas SiX² in general formula (3) above represents a reactive functional group in the silanol condensation reaction.

Examples of the halogen atom represented by X² in general formula (3) above include the same halogen atom as that represented by X¹ in general formula (2) above.

Examples of the alkoxy group by R² in general formula (3) above include the same alkoxy group as that represented by X¹ in general formula (2) above.

In general formula (3) above, X²s may be the same or different from each other. Preferably, X²s are the same.

Of X² in general formula (3) above, a preferable example is an alkoxy group, and a more preferable example is a methoxy group.

Examples of such the epoxy group-containing silicon compound include an epoxy group-containing trialkoxysilane, an epoxy group-containing silane trihalide, an epoxy group-containing triphenoxysilane, and an epoxy group-containing triacetoxysilane.

Such the epoxy group-containing silicon compound may be used either alone or as a combination thereof.

Of such the epoxy group-containing silicon compound, a preferable example is an epoxy group-containing trialkoxysilane.

Specifically, examples of the epoxy group-containing trialkoxysilane include a glycidoxyalkyltrimethoxysilane such as a glycidoxymethyltrimetoxysilane, a (2-glycidoxyethyl)trimethoxysilane, and a (3-glycidoxypropyl)trimethoxysilane; a (3-glycidoxypropyl)triethoxysilane; a (3-glycidoxypropyl)tripropoxysilane; and a (3-glycidoxypropyl)triisopropoxysilane.

Of such the epoxy group-containing trialkoxysilane, a preferable example is a glycidoxyalkyltrialkoxysilane, and a more preferable example is a (3-glycidoxypropyl)trimethoxysilane.

The epoxy group-containing silicon compound is blended at a mixing ratio of, for example, 0.01 to 90 parts by mass, preferably 0.01 to 50 parts by mass, and more preferably 0.01 to 1 parts by mass with respect to 100 parts by mass of the condensation materials.

The epoxy group-containing silicon compound may be a commercially available product or a product synthesized for use according to a known method.

The molar ratio (SiOH/(SiX¹ + SiX²)) of the silanol group (SiOH group) of the polysiloxane containing silanol groups at both ends to the reactive functional groups (SiX¹ group and SiX² group)of the ethylenical silicon compound and the epoxy group-containing silicon compound is of, for example 20/1 to 0.2/1, preferably 10/1 to 0.5/1, and more preferably 1/1 substantially.

When the molar ratio exceeds the above-described maximum, the semi-cured product having moderate toughness may fail to be obtained upon semi-curing the first thermosetting silicone resin composition. On the other hand, when the molar ratio is less than the above-described minimum, a mixing ratio of the ethylenical silicon compound and the epoxy group-containing silicon compound becomes too high, resulting in poor heat resistance of the encapsulating resin layer 3 to be obtained.

Moreover, when the molar ratio falls within the above-mentioned range (preferably 1/1 substantially), the silanol group (SiOH group) of the polysiloxane containing silanol groups at both ends, and the reactive functional group (SiX¹ group) of the ethylenical silicon compound and the reactive functional group (SiX² group) of the epoxy group-containing silicon compound are allowed to react just enough (neither excessive nor insufficient) in the condensation reaction.

The molar ratio of the ethylenical silicon compound to the epoxy group-containing silicon compound is of, for example, 10/90 to 99/1, preferably 50/50 to 97/3, and more preferably 80/20 to 95/5.

The molar ratio within the above-mentioned range leads to an advantage of an enhanced adhesive property with strength of a cured product being ensured.

The organohydrogensiloxane is organosiloxane having, in one molecule, at least two hydrosilyl groups without containing an ethylenically unsaturated hydrocarbon group.

Specifically, examples of the organohydrogensiloxane include an organopolysiloxane containing a hydrogen atom in its side chain and an organopolysiloxane containing hydrogen atoms at both ends.

The organopolysiloxane containng a hydrogen atom in its side chain is an organohydrogensiloxane having a hydrogen atom as its side chain branched from a main chain. Examples thereof include a methylhydrogenpolysiloxane, a dimethylpolysiloxane-co-methylhydrogenpolysiloxane, an ethylhydrogenpolysiloxane, and a methylhydrogenpolysiloxane-co-methylphenylpolysiloxane.

The number average molecular weight of the organopolysiloxane containing a hydrogen atom in its side chain is of, for example, 100 to 1,000,000.

The organopolysiloxane containing hydrogen atoms at both ends is an organohydrogensiloxane having hydrogen atoms at both ends of a main chain. Examples thereof include a polydimethylsiloxane containing hydrosilyl groups at both ends, a polymethylphenylsiloxane containing hydrosilyl groups at both ends, and a polydiphenylsiloxane containing hydrosilyl groups at both ends.

The number average molecular weight of the organopolysiloxane containing hydrogen atoms at both ends is of, for example, 100 to 1,000,000, and preferably 100 to 100,000 in view of stability and/or a handling property.

Such the organohydrogensiloxane may be used either alone or as a combination thereof.

Of such the organohydrogensiloxane, a preferable example is an organopolysiloxane containing a hydrogen atom in its side chain, and a more preferable example is a dimethylpolysiloxane-co-methylhydrogenpolysiloxane.

The viscosity at 25°C of the organohydrogensiloxane is preferably from 10 to 100,000 mPa·s, and more preferably from 20 to 50,000 mPa·s. Here, the viscosity is determined by an E-type viscometer (type of rotor: 1"34'xR24, the number of revolutions: 10 rpm). The viscosity of materials other than the organohydrogensiloxane or composition to be mentioned later is determined in the same manner as the above.

The hydrosilyl group equivalent in the organohydrogensiloxane is of, for example, 0.1 to 30 mmol/g, preferably 1 to 20 mmol/g.

The organohydrogensiloxane may be a commercially available product or a product synthesized for use according to a known method.

The mixing ratio of the organohydrogensiloxane is also based on the molar ratio of the ethylenically unsaturated hydrocarbon group of the ethylenical silicon compound (R² in general formula (2) above) to the hydrosilyl group (SiH group) of the organohydrogensiloxane. Alternatively, the mixing ratio of the organohydrogensiloxane is of, for example, 10 to 10,000 parts by mass, and preferably 100 to 1,000 parts by mass with respect to 100 parts by mass of the ethylenical silicon compound.

The molar ratio (R²/SiH) of the ethylenically unsaturated hydrocarbon group (R² in general formula (2) above) of the ethylenical silicon compound to the hydrosilyl group (SiH group) of the organohydrogensiloxane is of, for example, 20/1 to 0.05/1, preferably 20/1 to 0.1/1, more preferably 10/1 to 0.1/1, even more preferably 10/1 to 0.2/1, and particularly preferably 5/1 to 0.2/1. Moreover, the molar ratio may be set to be, for example, less than 1/1 to 0.05/1 or more.

The molar ratio over the value of 20/1 may fail to obtain the semi-cured product having moderate toughness upon semi-curing the first thermosetting silicone resin composition. On the other hand, the molar ratio less than the value of 0.05/1 may cause an extremely high mixing ratio of the organohydrogensiloxane, resulting in poor heat resistance and toughness of the encapsulating resin layer 3 to be obtained.

Moreover, the composition having the molar ratio less than 1/1 to 0.05/1 or more exhibits a faster rate of curing the composition to a semi-cured state when the first thermosetting silicone resin composition is semi-cured, and thus can be cured within a shorter period of time as compared with the first thermosetting silicone resin composition having the molar ratio of 20/1 to 1/1.

The first thermosetting silicone resin composition is prepared through blending and mixing by stirring with a catalyst the polysiloxane containing silanol groups at both ends, the ethylenical silicon compound, the epoxy group-containing silicon compound, and the organohydrogensiloxane mentioned above.

Examples of the catalyst include a condensation catalyst, and an addition catalyst (hydrosilylation catalyst.)

The condensation catalyst is not particularly limited as long as it is a compound that enhances the reaction rate of the condensation reaction of the silanol groups and the reactive functional groups (SiX¹ group in general formula (2) above and SiX² group in general formula (3) above). Examples of the condensation catalyst include acids such as hydrochloric acid, acetic acid, formic acid and sulfuric acid; bases such as potassium hydroxide, sodium hydroxide, potassium carbonate and tetramethylammonium hydroxide; and a metal such as aluminum, titanium, zinc and tin.

Such the condensation catalyst may be used either alone or as a combination thereof.

Of such the condensation catalyst, a preferable example is bases, and a more preferable example is tetramethylammonium hydroxide in view of compatibility and thermal decomposability.

The mixing ratio of such the condensation catalyst is of, for example, 0.1 to 50 mole, and preferably 0.5 to 5 mole relative to 100 mole of the polysiloxane containing silanol groups at both ends.

The addition catalyst is not particularly limited as long as it is a compound that enhances the reaction rate of the hydrosilylation reaction of the ethylenically unsaturated hydrocarbon group and the SiH group. Examples of the addition catalysts include metal catalyst including platinum catalyst such as platinum black, platinum chloride, chloroplatinic acid, a platinum-olefin complex, a platinum-carbonyl complex, and platinum-acetyl acetate; palladium catalyst; and rhodium catalyst.

Such the addition catalyst may be used either alone or as a combination thereof.

Of the catalysts, in view of compatibility, transparency, and catalytic activity, a preferable example is platinum catalyst, and a more preferable example is platinum-olefin complex.

For instance, the mixing ratio of the addition catalyst as the number of parts by mass of the metal in the addition catalyst is preferably from 1.0 x 10⁻⁴ to 1.0 parts by mass, more preferably from 1.0 x 10⁻⁴ to 0.5 parts by mass, and even more preferably from 1.0 x 10⁻⁴ to 0.05 parts by mass with respect to 100 parts by mass of the organohydrogensiloxane.

The above-described catalyst in a solid state may be used as it is. Alternatively, it may be used as a solution or dispersion in which the catalyst is dissolved or dispersed in a solvent in view of a handling property.

Examples of the solvent include organic solvent including alcohols such as methanol and ethanol; silicon compounds such as a siloxane; aliphatic hydrocarbons such as hexane; aromatic hydrocarbons such as toluene; and ethers such as tetrahydrofuran (THF). Examples of the solvent further include an aqueous solvent such as water.

A preferable example of the solvent is alcohol when the catalyst is a condensation catalyst, whereas a preferable example of the solvent is a silicon compound and an aromatic hydrocarbon when the catalyst is an addition catalyst.

For preparing the first thermosetting silicone resin composition, the above-described materials (the condensation material and the addition material) and the catalyst may be added simultaneously, or each material and each catalyst can be added at different timings. Moreover, some components may be added simultaneously and each residual component may be added at different timings.

Of such the preparing methods of the first thermosetting silicone resin composition, a preferable example is a method of firstly adding the condensation materials and the condensation catalyst simultaneously, and thereafter adding the addition materials and then adding the adding catalyst.

Specifically, the polysiloxane containing silanol groups at both ends, the ethylenical silicon compound, and the epoxy group-containing silicon compound (i.e., the condensation materials), and the condensation catalyst are simultaneously blended at the above-mentioned ratio to be mixed by stirring for 5 minutes to 24 hours, for instance.

For enhancing compatibility and a handling property of the condensation materials, temperature can be adjusted to, for example, 0 to 60°C, preferably 10 to 40°C upon blending and mixing by stirring.

Subsequently, a volatile component (organic solvent) is removed from the system by reducing pressure as required.

Subsequently, the organohydrogensiloxane is blended with a mixture of the condensation materials and the condensation catalyst to be obtained, and then they are mixed by stirring for 1 to 120 minutes, for instance.

For enhancing compatibility and a handling property of the mixture and the organohydrogensiloxane, temperature can be adjusted to, for example, 0 to 60°C, upon blending and mixing by stirring.

Subsequently, the addition catalyst is blended with the system, and then they are mixed by stirring for 1 to 60 minutes, for instance.

Thus, the first thermosetting silicone resin composition can be prepared.

The prepared first thermosetting silicone resin composition is, for example, in a liquid state at room temperature (in an oil state).

The viscosity at 25°C of the first thermosetting silicone resin composition is preferably 1,000 to 50,000 mPa·s, and more preferably 4,000 to 20,000 mPa·s.

The condensation/addition reaction curing-type silicone resin composition is, for example, in a liquid state at room temperature (in an oil state), and is applied on the surface of the base substrate 4, to be mentioned later, and then is heated. Then, the condensation materials are subjected to a condensation reaction. Thus, the condensation/addition reaction curing-type silicone resin composition is prepared. Thereafter, a light emitting diode element 2, to be mentioned later, is embedded in the encapsulating resin layer 3 composed of the condensation/addition reaction curing-type silicone resin composition (see Figure 1(b)). Then the encapsulating resin layer 3 is pressed and heated, whereby the addition materials are subjected to an addition reaction to form the cured encapsulating resin layer 3 (see Figure 1(c)).

Specifically, a first thermosetting silicone resin composition contains a polydimethylsiloxane containing silanol groups at both ends, a vinyltrimetoxysilane, a (3-glycidoxypropyl)trimethoxysilane, and a dimethylpolysiloxane-co-methylhydrogenpolysiloxane. A second thermosetting silicone resin composition contains a dimethylvinylsilyl terminated polydimethylsiloxane, a trimethylsilyl terminated dimethylsiloxane-methylhydrosiloxane copolymer, a platinum-divinyltetramethyldisiloxane complex, and tetramethylammonium hydroxide. A third thermosetting silicone resin composition contains a hydrogen terminated vinylmethylsiloxane-dimethylsiloxane copolymer, a trimethylsiloxy terminated dimethylsiloxane-methylhydrosiloxane copolymer, a platinum-carbonyl complex, and tetramethylammonium hydroxide. A fourth thermosetting silicone resin composition contains a hydroxy-group terminated vinylmethylsiloxane-dimethylsiloxane copolymer, a trimethylsiloxy-group terminated dimethylsiloxane-methylhydrosiloxane copolymer, a platinum-carbonyl complex, and tetramethylammonium hydroxide.

Moreover, the encapsulating resin composition can also contain microparticles.

Examples of the microparticle include organic microparticles such as silicone microparticles; and inorganic microparticles such as silica microparticles (e.g., aerosol silica microparticles), talc microparticles, alumina microparticles, aluminum nitride microparticles, and silicon nitride microparticles. Examples of the inorganic microparticles further include phosphor microparticles.

The same type of microparticles can be used singly or different types of microparticles can be used in combination.

Of the microparticles, a preferable example is inorganic microparticles, and a more preferable example is phosphor microparticles.

The phosphor microparticles are microparticles having a wavelength changing function, and examples thereof include well-known phosphor microparticles such as yellow phosphor microparticles that can convert blue light into yellow light and red phosphor microparticles that can convert blue light into red light.

Examples of the yellow phosphor microparticles include garnet-type phosphor microparticles having a garnet-type crystal structure such as Y₃Al₅O₁₂:Ce (YAG(yttrium aluminum garnet):Ce) and Tb₃Al₃O₁₂:Ce (rAG(terbium aluminum garnet):Ce); and oxynitride phosphor microparticles such as Ca-α-SiAlON.

Examples of the red phosphor microparticles include nitride phosphor microparticles such as CaAlSiN₃: Eu and CaSiN₂:Eu.

The yellow phosphor microparticles are preferable.

Examples of shape of each of the microparticles include a spherical shape, a plate shape, and a needle shape. A spherical shape is preferable in view of mobility.

An average value of the maximum length of microparticles (an average particle diameter where it is spherical) is, for example, 0.1 to 200 µm, and preferably 1 to 100 µm in view of an optical property and a handling property. The average value of the maximum length is determined using a laser diffraction/scattering particle size distribution analyzer.

The microparticles are blended at a mixing ratio of, for example, 0.1 to 80 parts by mass, in view of ensuring mobility, preferably 0.5 to 50 parts by mass with respect to 100 parts by mass of the silicone resin.

A well-known additive may be added to the encapsulating resin composition mentioned above at an appropriate ratio. Examples of the additives include silane coupling agents, antioxidants, modifiers, surfactants, dyes, pigments, discoloration inhibitors, and ultraviolet absorbers.

For preparing the encapsulating resin composition, the resin, microparticles as required, and the additive agents as required are blended at the mixing ratio mentioned above, and then they are mixed.

As mixing conditions, the temperature is, for example, 10 to 40°C, preferably 15 to 35°C, and the time is, for example, 10 minutes or more, and preferably 30 minutes or more.

The viscosity at 25°C of the encapsulating resin composition is, for example, 1,000 to 100,000 mPa·s, and preferably 5,000 to 50,000 mPa·s.

The viscosity of the encapsulating resin composition less than the above minimum value may cause poor moldability or workability, whereas the viscosity more than the above maximum value may cause a decreased handling property (an application property).

Subsequently, the applied resin composition is heated.

The heating temperature is, for example, 40 to 150°C, preferably 60 to 140°C. The heating time is, for example, 1 minute to 24 hours, preferably 10 minutes to 12 hours.

When the resin composition is a thermosetting resin, the heating temperature is set such that the encapsulating resin layer 3 is not cured completely.

When the resin composition is a thermosetting resin, the encapsulating resin layer 3 is in a semi-cured state (B-stage) by heating as above.

Specifically, when the resin composition is composed of the condensation/addition reaction curing-type silicone resin composition, it is subjected to a condensation reaction (silanol condensation) through heating to be brought into the semi-cured state (B-stage).

The compressive elasticity modulus at 25°C of the encapsulating resin layer 3 is, in view of encapsulating and a handling property, for example 0.01 to 1 MPa, preferably 0.01 to 0.5 MPa, and more preferably 0.01 to 0.2 MPa.

The compressive elasticity modulus of the encapsulating resin layer 3 less than the above range may cause a decreased shape retention property of the encapsulating resin layer 3. On the other hand, the compressive elasticity modules of the encapsulating resin layer 3 over the above range may cause damaged wires upon embedding the light emitting diode element 2 connected to the substrate by wire bonding.

The compressive elasticity modulus of the encapsulating resin layer 3 is determined by compression tests using a precision load measuring apparatus.

When the encapsulating resin composition is a thermosetting resin, the compressive elasticity modulus of the encapsulating resin layer 3 in the B-stage is determined.

The thickness of the encapsulating resin layer 3 is not particularly limited. It is adjusted appropriately such that the encapsulating resin layer 3 can embed the light emitting diode element 2 upon encapsulating the light emitting diode element 2, which is to be mentioned later.

The encapsulating resin layer 3 has a thickness of, for example, 50 to 5,000 µm, and preferably 100 to 1,000 µm. When the thickness of the encapsulating resin layer 3 is less than the above range, the light emitting diode element 2 (especially, the light emitting diode element 2 and the wire in wire bonding of the light emitting diode element) may fail to be embedded (buried).

The encapsulating resin layer 3 having a thickness less than the above range may cause poor encapsulating of the light emitting diode element 2.

Such the encapsulating resin layer 3 may be formed from one layer, or may be formed from two or more layers.

Thus, as illustrated in Figure 2(b), an encapsulating sheet 5 is prepared having the base substrate 4 and the encapsulating resin layer 3 formed on the surface thereof.

Subsequently, in the method, the light emitting diode element 2 is embedded in the encapsulating resin layer 3 as illustrated in Figures 1(a) and 1(b) (i.e., an embedding step).

The light emitting diode element 2 is, for example, mounted on a substrate 6.

The substrate 6 is formed from, for example, a metal plate composed of aluminum and the like, or a resin plate composed of polyimide and the like.

The substrate 6 has a terminal (not shown) on a surface thereof, and has the light emitting diode element 2 mounted in the central portion thereof.

Here, the light-emitting diode element 2 is electrically connected to the terminal of the substrate 6 by wire bonding or a flip chip.

The light emitting diode element 2 is, for example, an optical semiconductor element that can emit blue light (specifically a blue light emitting diode element.) The light emitting diode element 2 is formed into generally rectangular shape when viewed in cross section.

The light emitting diode element 2 is in a generally rectangular flat plate shape in plan view. The light emitting diode element 2 has one side with a length of, for example, 0.1 to 5 mm, and has a thickness of, for example, 10 to 1,000 µm.

As illustrated in Figure 1(a), the encapsulating sheet 5 is arranged firstly so as to be opposed to the substrate 6 for embedding the light emitting diode element 2 in the encapsulating resin layer 3. Specifically, the encapsulating resin layer 3 is arranged so as to be opposed to the light emitting diode element 2. That is, the encapsulating resin layer 3 and the light emitting diode element 2 are positioned such that the central portion of the encapsulating resin layer 3 faces the light emitting diode element 2. Here, the encapsulating sheet 5 and the substrate 6 may be supported by a suction unit, etc., not shown.

Subsequently, the encapsulating sheet 5 is moved downward (pressed down) as illustrated by an arrow in Figure 1(a), whereby the surface of the light emitting diode element 2 is covered with the encapsulating resin layer 3.

More specifically, the encapsulating sheet 5 is compressively bonded to the substrate 6.

Thus, the light emitting diode element 2 is embedded in the encapsulating resin layer 3.

When the light emitting diode element 2 is embedded in the encapsulating resin layer 3 in accordance with press down of the encapsulating sheet 5, a crimping device such as a pressing device and a lamination device is used.

A pressing device is preferably used as the crimping device.

Examples of the pressing device include an atmospheric-pressure/room-temperature atmosphere pressing device, such as a press device, that presses an object under an atmospheric-pressure/room-temperature atmosphere; an atmospheric-pressure/room-temperature atmosphere pressing/heating-device, such as a thermal press device, that presses and heats an object under an atmospheric-pressure/room-temperature atmosphere; a reduced-pressure/room-temperature atmosphere pressing device, such as a vacuum press device, that presses an object under a reduced-pressure/room-temperature atmosphere; and a reduced-pressure/room-temperature atmosphere pressing/heating-device, such as a vacuum thermal press device, that presses and heats an object under a reduced-pressure/room-temperature atmosphere.

Preferable examples of the pressing device are an atmospheric-pressure/room-temperature atmosphere pressing/heating-device and a reduced-pressure/room-temperature atmosphere pressing device.

Moreover, use of the reduced-pressure/room-temperature atmosphere pressing device or the reduced-pressure/room-temperature atmosphere pressing/heating-device can achieve effective removal of air dissolved in the resin composition of the encapsulating resin layer 3 from the resin composition. Consequently, occurrence of voids in the encapsulating resin layer 3 can be prevented effectively.

When each of pressing devices mentioned above is used, the encapsulating sheet 5 and the substrate 6 are pressed under pressure (pressing pressure) of, for example, 0.01 to 10 MPa, preferably 0.05 to 5 MPa.

Moreover, when the atmospheric-pressure/room-temperature atmosphere pressing/heating-device or the reduced-pressure/room-temperature atmosphere pressing/heating-device is used, the heating temperature is more than room temperature (25°C) and not more than 180°C, preferably more than room temperature and not more than 150°C. Here, when the encapsulating resin composition is a thermosetting resin and the encapsulating resin layer 3 to be bonded compressively is in the B-stage, the temperature is set such that the encapsulating resin layer 3 is not completely cured.

When the reduced-pressure/room-temperature atmosphere pressing device or the reduced-pressure/room-temperature atmosphere pressing/heating-device is used, pressure (atmosphere) within the device is, for example, 0.01 to 100 hPa, preferably 0.01 to 10 hPa.

A crimping time is, for example, 0.1 to 60 minutes, preferably 0.1 to 20 minutes.

Specifically, the encapsulating sheet 5 and the substrate 6 are set on the above-described crimping device, and the device is operated under the conditions above.

Subsequently, in the method, the encapsulating resin layer 3 having the light emitting diode element 2 embedded therein is heated while being pressed with gas (i.e., a gas-pressing/heating step), as illustrated in Figure 1(c).

The encapsulating resin layer 3 is pressed with gas using, for example, a high-pressure/high-temperature atmosphere treatment device, such as an autoclave, that performs treatment under a high-pressure/high-temperature atmosphere.

The high-pressure/high temperature atmosphere treatment device presses the encapsulating resin layer 3 with gas, such as air, nitrogen, and carbon dioxide. Preferably, the encapsulating resin layer 3 is presses with air.

In the high-pressure/high-temperature atmosphere treatment device, pressure is gage pressure and, for example, 2 to 20 atmospheres (0.2026 to 2.026 MPa), preferably 5 to 10 atmospheres (0.5065 to 10.13 MPa).

The pressure less than the above range may fail to effectively prevent voids from occurring in the encapsulating resin layer 3. On the other hand, the pressure over the above range may fail to ensure desire sufficient safety.

In the high-pressure/high-temperature atmosphere treatment device, the temperature is, for example, 80 to 200°C, preferably 120 to 180°C.

The heating and the pressing time is, for example, 0.1 to 24 hours, preferably 0.5 to 5 hours.

Specifically, the encapsulating resin layer 3 having the light emitting diode element 2 embedded therein is set on the above-described high-pressure/high-temperature atmosphere treatment device, and the device is operated under given conditions.

Moreover, when the encapsulating resin composition is a thermosetting resin and the encapsulating resin layer 3 is in the B-stage, the encapsulating resin layer 3 is heated while being pressed with gas to be brought into a C-stage (i.e., completely cured).

That is, when the encapsulating resin composition of the encapsulating resin layer 3 is a condensation/addition reaction curing-type silicone resin composition, the addition materials are subjected to an addition reaction to form the cured encapsulating resin layer 3.

Thus the encapsulating resin layer 3 having the light emitting diode element 3 embedded therein is heated while being pressed with gas, whereby the encapsulating resin layer 3 encapsulates the light emitting diode element 2.

Subsequently, in the method, the base substrate 4 is peeled off from the encapsulating resin layer 3 as illustrated by imaginary lines in Figure 1 (c).

Thus, a light emitting diode device 1 having the substrate 6, the light-emitting diode element 2 mounted on the substrate 6, and the encapsulating resin layer 3 with the light-emitting diode element 2 embedded therein is obtained.

Subsequently, a functional layer, not shown, such as a phosphor layer and a light diffusion layer, can also be provided as required on the surface (top face) of the encapsulating resin layer 3.

Then according to the production method of the light emitting diode device 1, the encapsulating resin layer 3 with the light emitting diode element 2 embedded therein is heated while being pressed with gas.

Thus, a load applied to the apparatus, specifically the high-pressure/high-temperature atmosphere treatment device, can be suppressed when pressure is higher and a heating time becomes longer.

Moreover, pressing with gas can achieve uniform forced pressure on the light emitting diode element 2 under higher pressure. As a result, damages of the light emitting diode element 2 and occurrence of voids in the encapsulating resin layer 3 can be suppressed.

Here in the embodiment illustrated in Figure 1(a), one light emitting diode element 2 is mounted on one substrate 6. Alternatively, two or more light emitting diode devices 1, not shown, may be mounted. In this case, as referred to Figure 1(c), the encapsulating resin layer 3 is heated while being pressed with gas, and thereafter each light emitting diode devices 1 are individually divided into pieces.

Moreover, each step in Figures 1(a) and 1(b) can be performed in a continuous mode such as roll-to-roll, or in a batch mode, not shown.

### Examples

While the present invention will hereinafter be described in further detail with reference to Preparation Examples, Examples, and Comparative Examples, the present invention is not limited to these Examples.

### Preparation Example 1

### <Preparation of Condensation/Addition Reaction Curing-Type Silicone Resin Composition>

15.71g (0.106 mol) of a vinyltrimetoxysilane (an ethylenical silicon compound) and 2.80g (0.0118 mol) of a (3-glycidoxypropyl)trimethoxysilane (an epoxy group-containing silicon compound) were blended to 2031g (0.177 mol) of a polydimethylsiloxane containing silanol groups at both ends (a polydimethylsiloxane containing silanol groups at both ends, in general formula (1), all of the R¹s are methyl, an average of n of 155, the number average molecular weight of 11,500, silanol group equivalent of 0.174 mmol/g), and they were stirred.

Here, the molar ratio (the number of moles of SiOH group/the total number of moles of SiOCH₃ groups) of SiOH group of the polydimethylsiloxane containing silanol groups at both ends to SiOCH₃ groups of the vinyltrimetoxysilane and the (3-glycidoxypropyl)trimethoxysilane was 1/1.

After stirring and mixing, 0.97 mL (0.766g, a catalyst content: 0.88 mmol, equivalent to 0.50 mol with respect to 100 mol of the polydimethylsiloxane containing silanol groups at both ends) of a methanol solution of tetramethylammonium hydroxide (a condensation catalyst, a concentration of 10 mass%) was added and stirred at 40°C for 1 hour. Thereafter, volatile components (such as methanol) were removed while they were stirred at 40°C under reduced pressure (10mmHg) for 1 hour.

Thereafter, the system is returned to atmospheric pressure, and then 44.5 g (0.022 mol) of an organohydrogensiloxane (manufactured by Shin-Etsu Chemical Co., Ltd., a dimethylpolysiloxane-co-methylhydrogenpolysiloxane, a number average molecular weight of 2,000, hydrosilyl group equivalent of 7.14 mmol/g) was added to be stirred at 40°C for 1 hour.

Here, the molar ratio (CH₂=CH-/SiH) of the vinyl group (CH₂=CH-) of the vinyltrimethoxymethylsilane to the hydrosilyl group (SiH group) of the organohydrogensiloxane was 1/3.

Thereafter, 0.13g (0.13 mL, a platinum content of 2 mass%, equivalent to 5.8x10⁻³ parts by mass as platinum with respect to 100 parts by mass of the organohydrogensiloxane) of the siloxane solution of a platinum-carbonyl complex (an addition catalyst, a platinum concentration of 2 mass%) was added to the system and was stirred at 40°C for 1 hour, so that a thermosetting silicone resin composition in a liquid state at room temperature (condensation/addition reaction curing type) was obtained.

### Example 1

### <Preparation of Resin Composition>

100 parts by mass of the thermosetting silicone resin compositions in Preparation Example 1 were blended with 26 pats by mass of YAG:Ce (a spherical shape, an average particle diameter of 10 µm) to prepare an encapsulating resin composition in a liquid state at room temperature.

The prepared encapsulating resin composition was applied on an entire surface of a base substrate (see Figure 2(a)) composed of a PET film using a doctor blade method, and then was heated at 135°C for 20 minutes, so that an encapsulating sheet was prepared provided with the base substrate and an encapsulating resin layer in a B-stage having a thickness of 600 µm to be laminated on a surface of the base substrate (see Figure 2(b)).

Subsequently, an encapsulating sheet was cut into a 5cm square. Then the encapsulating sheet was positioned relative to the substrate having 25 blue light emitting diode elements (size of 0.35 mm × 0.35 mm) mounted in the area of 5cm square, so that they faced to each other (see Figure 1(a)).

Subsequently, the encapsulating sheet and the substrate were set on a press device, and were compressively bonded for 1 minute at pressing pressure of 0.1 MPa at room temperature under an atmospheric-pressure atmosphere, so that the blue light emitting diode element is embedded in the encapsulating resin layer (i.e., an embedding step, see Figure 1(b)).

Thereafter, the encapsulating sheet and the substrate were set on an autoclave, and were heated at 7.5 atmospheres (gage pressure: 0.759 MPa) and at 150°C for 2 hours. Thus, the encapsulating resin layer was completely cured, and the blue light emitting diode element was encapsulated with the encapsulating resin layer (a gas-pressing/heating step, see Figure 1(c)).

In this way, the light emitting diode device was produced.

Subsequently, the base substrate was peeled off from the encapsulating resin layer (see imaginary lines in Figure 1(c)), and then dicing was performed thereto and each blue light-emitting diode elements were individually divided into pieces.

### Example 2

The blue light emitting diode element was embedded in the encapsulating resin layer, and the encapsulating resin layer was completely cured and then the light emitting diode device was produced in the same manner as in Example 1 except for pressing at a room-temperature/reduced-pressure atmosphere using a vacuum press device instead of the press device in the embedding step.

The reduced pressure condition of the vacuum press device was 1 hPa (0.0001 MPa).

### Example 3

The same processes were performed as in Example 1 except for changing the pressure condition of the autoclave in the gas-pressing/heating step from 7.5 atmospheres (gage pressure: 0.759 MPa) to 5.0 atmospheres (gage pressure: 0.507 MPa), so that the encapsulating resin layer was completely cured. Thus, the light emitting diode device was produced.

### Example 4

The same processes were performed as in Example 1 except for changing the pressure condition of the autoclave in the gas-pressing/heating step from 7.5 atmospheres (gage pressure: 0.759 MPa) to 1.8 atmospheres (gage pressure: 0.182 MPa), so that the encapsulating resin layer was completely cured. Thus, the light emitting diode device was produced.

### Comparative Example 1

The same processes were performed as in Example 1 except that a hot-air type oven was used, instead of the autoclave in the gas-pressing/heating step, for heating at 150°C for 2 hours at a room temperature atmosphere, so that the encapsulating resin layer was completely cured. Thus, the light emitting diode device was produced.

### Comparative Example 2

The same processes were performed as in Example 4 except that a press device was used, instead of the autoclave in the gas-pressing/heating step, for heating at 150°C for 2 hours at 0.182 MPa (equivalent to a pressing pressure of 1.8 atmospheres) at a room temperature atmosphere, so that the encapsulating resin layer was completely cured. Thus, the light emitting diode device was produced.

### Comparative Example 3

The same processes were performed as in Example 4 except that a press device was used, instead of the autoclave in the gas-pressing/heating step, for heating at 150°C for 2 hours at 0.507 MPa (equivalent to a pressing pressure of 5 atmospheres) at a room temperature atmosphere, so that the encapsulating resin layer was completely cured. Thus, the light emitting diode device was produced.

The encapsulating sheet, however, was deformed and warped, and a desired light emitting diode device was not obtained.

(Evaluation)

### (1) Damage on Blue Light Emitting Diode Element

The blue light emitting diode elements of the light emitting diode devices in Examples 1 through 4 and Comparative Examples 1 and 2 were observed and evaluated based on the following evaluation criteria. The results are shown in Table 1.

Good: No damage on the blue light emitting diode element was observed.
Bad: Damages on the blue light emitting diode element were observed.

### (2) Voids in Encapsulating Resin Layer

The blue light emitting diode elements of the light emitting diode devices in Examples 1 through 4 and Comparative Examples 1 and 2 were observed and evaluated based on the following evaluation criteria. The results are shown in Table 1.

Good : No void was observed in the encapsulating resin layer.
Poor: Only a few voids were observed in the encapsulating resin layer.
Bad: Voids were observed in the encapsulating resin layer.

(3) Compressive Elasticity Modulus of Encapsulating Resin Layer

A compressive elasticity modulus of the encapsulating resin layer in a B-stage was determined at 25°C using a precise load measuring device (model 1605II VL, manufactured by AIKOH ENGINEERING CO., LTD).

The result was 0.04MPa.

### Table 1

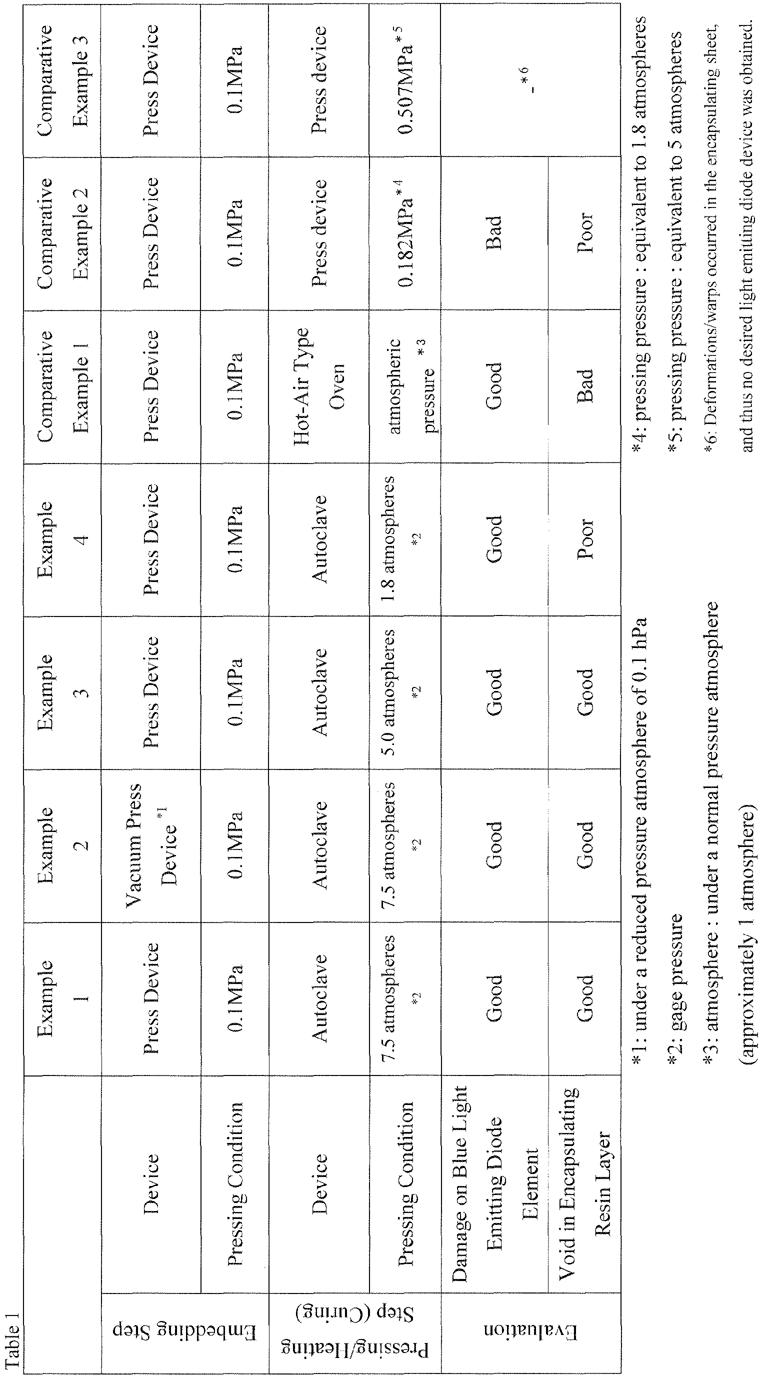

## Claims

1. A method of producing a light emitting diode device (1) having a light emitting diode element (2) being encapsulated by an encapsulating resin layer (3)comprising:
preparing and encapsulating resin layer (3);
embedding a light emitting diode element (2) in the encapsulating resin layer (3); and heating while pressing with gas the encapsulating resin layer (3) having the light emitting diode element (2) being embedded therein.

2. The method of producing the light emitting diode device (1) according to claim 1, wherein the encapsulating resin layer (3) is composed of a thermosetting resin in a B-stage.

3. The method of producing the light emitting diode device (1) according to claim 1 or 2, wherein the encapsulating resin layer (3) has a compressive elasticity modulus of 0.01 to 1 MPa at 25°C.

4. The method of producing the light emitting diode device (1) according to claim 1, 2 or 3, wherein the encapsulating resin layer (3) is pressed at 2 to 20 atmospheres in the step of heating while pressing with gas the encapsulating resin layer.

5. The method of producing the light emitting diode device (1) according to any of claims 1 to 4, wherein the encapsulating resin layer (3) is heated while being pressed by an autoclave in the step of heating while pressing with gas the encapsulating resin layer.

6. A light emitting diode device (1) having a light emitting diode element (2) being encapsulated by an encapsulating resin layer (3) the light emitting diode device being produced by a method according to any of claims 1 to 5.
